# EUROPÄISCHE PATENTSCHRIFT

(11) **EP 0 895 446 B1**
(45) Veröffentlichungstag und Bekanntmachung des Hinweises auf die Patenterteilung: **21.06.2006**
(21) Anmeldenummer: 98112608.9
(22) Anmeldetag: 08.07.1998
(51) Int. Cl.: H05K 1/18, H01L 25/16

(54) **Regler für einen Elektromotor mit Regelschaltung und Leistungshalbleiter**
Controller for an electrical motor with a regulating circuit and a power semiconductor
Contrôleur pour un moteur électrique avec un circuit de régulation et un semi-conducteur de puissance

(30) Priorität: 31.07.1997 DE 19733047
(43) Veröffentlichungstag der Anmeldung: 03.02.1999
(73) Patentinhaber: GKR Gesellschaft für Fahrzeugklimaregelung mbH, 71701 Schwieberdingen (DE)
(72) Erfinder: Breitling, Wolfram, 74343 Sachenheim (DE); Klein, Jürgen, 71735 Eberdingen (DE); Falliano, Rolf, 73635 Steinenberg (DE)
(74) Vertreter: Behrens, Ralf Holger

(56) Entgegenhaltungen:
- EP-A- 0 465 084
- EP-A- 0 685 939
- EP-A- 0 751 570
- DE-A- 19 523 010
- DE-C- 19 513 619
- US-A- 5 159 532
- US-A- 5 245 510
- US-A- 5 513 072
- PATENT ABSTRACTS OF JAPAN vol. 1997, no. 6, 30. Juni 1997 (1997-06-30) -& JP 09 045851 A (MATSUSHITA ELECTRON CORP), 14. Februar 1997 (1997-02-14)
- PATENT ABSTRACTS OF JAPAN vol. 16, no. 221 (E-1205), 22. Mai 1992 (1992-05-22) -& JP 04 037159 A (MITSUBISHI ELECTRIC CORP), 7. Februar 1992 (1992-02-07)

## Beschreibung

### Stand der Technik

Die Erfindung betrifft einen Regler für einen Elektromotor, der mit Anschlüssen für den Elektromotor, eine Versorgungsspannung und mindestens einen externen Sollwert versehen ist und neben den elektronischen Bauelementen für die Regelschaltung mindestens einen Leistungshalbleiter als Leistungsendstufe aufweist.

Die bekannten Regler dieser Art sind in der Regel mit einer Leiterplatte versehen, auf der die elektronischen Bauelemente aufgebracht und miteinander verdrahtet sind. Dabei können die Leistungshalbleiter auf Kühlkörpern befestigt sein und die gesamte Regelschaltung ist zum Schutz gegen Umwelteinflüsse vergossen oder in einem Kunststoffgehäuse untergebracht. Ein derartiger Regler erfordert nicht nur einen hohen Teileaufwand, sondern auch einen erheblichen Montageaufwand, so daß seine Herstellungskosten beachtlich sind. Durch die vielen Lötstellen zwischen den elektronischen Bauelementen und den Leistungshalbleitern ist zudem die Qualität und Zuverlässigkeit des Reglers beeinträchtigt.

Es ist auch ein monolithischer Regler bekannt, dessen Herstellung jedoch aufgrund der immens hohen Entwicklungskosten nur bei sehr großen Stückzahlen zum Tragen kommt.

### Vorteile der Erfindung

Es ist Aufgabe der Erfindung, einen Regler der eingangs erwähnten Art zu schaffen, der ohne monolithischen Aufbau auch für kleinere Stückzahlen kostengünstig in guter Qualität und Zuverlässigkeit hergestellt werden kann.

Diese Aufgabe wird nach der Erfindung dadurch gelöst, daß alle elektronischen Bauelemente als Hybrid in und/oder auf einem Keramiksubstrat enthalten und miteinander verbunden sind, daß der Hybrid auf einer wärmeleitenden Trägerplatte befestigt ist, die mit einem Kühlkörper verbindbar ist, daß die Leistungshalbleiter außerhalb des Hybrids auf der Trägerplatte befestigt und mit ihren Anschlußelektroden elektrisch leitend mit dem Hybrid verbunden sind und daß die Anschlüsse des Reglers an dem Hybrid zugänglich angebracht sind.

Bei diesem Aufbau enthält der Hybrid die gesamte Regelschaltung, wobei die Widerstände als an sich bekannte gedruckte Hybridwiderstände ausgebildet sein können und in einfacher Weise über Laser abgeglichen werden können. Aufgrund der guten Wärmeleitfähigkeit und der guten Kopplung der Leistungshalbleiter mit der Trägerplatte ergeben sich im Vergleich zu den bekannten, auf einer Leiterplatte aufgebauten Reglern eine große Fläche und damit eine gute thermische Verbindung zur Trägerplatte. Der Regler braucht aufgrund der guten thermischen Kopplung zwischen den Leistungshalbleitern und der Trägerplatte aus Sicherheitsgründen auch nicht mehr überdimensioniert werden. Der neue Regler ist im Aufbau sehr kompakt, was insbesondere einer Miniaturisierung und Flexibilisierung zugutekommt. Die Zahl der Lötstellen ist durch den Hybrid stark reduziert, was sich nicht nur in einer Erhöhung der Qualität und Zuverlässigkeit, sondern auch in einer beachtlichen Kostenreduktion ausdrückt.

Hybrid und Trägerplatte werden dadurch zu einer Einheit, daß der Hybrid mit der Trägerplatte verklebt, verklemmt oder anderweitig mechanisch fest verbunden ist.

Für Anschlüsse ist nach einer Ausgestaltung vorgesehen, daß die Anschlüsse als Steckanschlüsse mit Gehäuse für einen Stecker ausgebildet sind. Diese Anschlußmöglichkeit ist insbesondere dann von Vorteil, wenn der Regler für einen Gebläse-Elektromotor in einem Kraftfahrzeug eingesetzt wird.

Die Anschlüsse können jedoch auch als Löt-, Klemm-, Schneid- oder Schraubanschlüsse ausgebildet sein.

Sind die Leistungshalbleiter als Siliziumchips (ohne Gehäuse) ausgebildet, dann können sie direkt mit der Trägerplatte verklebt oder verlötet werden. Außerdem können sie und ihre Verbindungsleitungen zu dem Hybrid mittels einer Schutzschicht abgedeckt werden.

Ist nach einer einer Ausgestaltung vorgesehen, daß bei einer Reglerschaltung mit Temperaturfühler diese in wärmeleitender Verbindung mit der Trägerplatte auf dieser selbst oder im Hybrid angeordnet sein. Die Leistungshalbleiter und der oder die Temperaturfühler stehen in gutem thermischen Kontakt, so daß der oder die Temperaturfühler sehr schnell auf die Temperaturänderungen an den Leistungshalbleitern reagieren kann oder können.

Der Wärmeübergang zwischen der Trägerplatte und einem an dieser angebrachten Kühlkörper läßt sich dadurch verbessern, daß die Trägerplatte über eine Schicht aus wärmeleitender Paste mechanisch fest mit dem Kühlkörper verbunden ist. Die Trägerplatte besteht vorzugsweise aus Kupfer, das eine gute Wärmeleitfähigkeit besitzt.

Von Vorteil ist auch eine Ausgestaltung, die dadurch gekennzeichnet ist, daß die Widerstände der Regelschaltung als gedruckte Hybridwiderstände ausgebildet sind, da diese Widerstände mittels Laser leicht abgeglichen werden können.

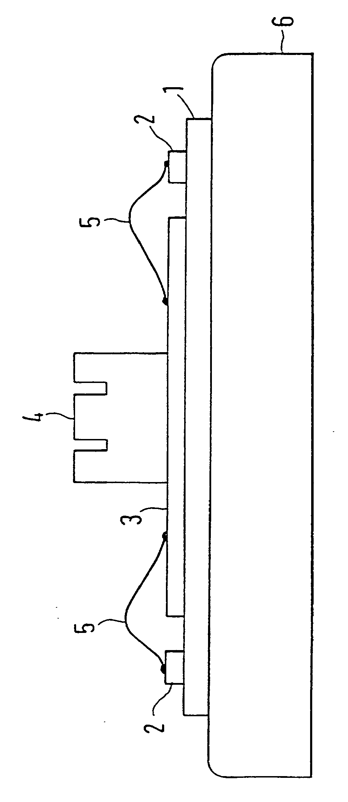

Die Erfindung wird anhand eines in der Zeichnung in einer Seitenansicht schematisch dargestellten Ausführungsbeispiels näher erläutert.

Auf einer vorzugsweise aus Kupfer bestehenden Trägerplatte 1 ist ein Hybrid 3 aufgebracht, der in einem Keramiksubstrat alle elektronischen Bauteile der Regelschaltung aufnimmt. In dem Hybrid 3 sind über Leiterbahnen die elektronischen Bauelemente bereits in ihrem Schaltungsverbund miteinander verbunden. Die Widerstände der Regelschaltung können dabei wie die Verbindungsleitungen in gedruckter Ausführung auf- und eingebracht sein. Der Hybrid 3 ist mechanisch mit der Trägerplatte 1 verbunden, wobei Kleben, Klemmen oder eine anderweitig feste mechanische Verbindung gewählt werden kann. Außerhalb des Hybrids 3 werden die Leistungshalbleiter 2 auf der Trägerplatte 1 befestigt und zwar so, daß sie wärmeleitend mit der Trägerplatte 1 verbunden sind, insbesondere dann, wenn sie als Siliziumchip ohne Gehäuse ausgebildet sind. Die Leistungshalbleiter 2 können mit der Trägerplatte 1 verklebt oder verlötet sein.

Die elektrische Verbindung des Leistungshalbleiters 2 mit dem Hybrid 3 übernehmen Verbindungsleitungen 5, die wie die Leistunghalbleiter 2 mit einer Schutzschicht abgedeckt sein können.

Die Anschlüsse 4 für den Elektromotor, die Versorgungsspannung und den externen Sollwert werden zugänglich am Hybrid 3 angebracht, wobei jede mögliche Anschlußtechnik verwendet werden kann. Die Anschlüsse 4 können als Löt-, Klemm-, Schneid- oder Schraubanschlüsse ausgebildet sein. Sind die Anschlüsse 4 als Steckanschlüsse ausgebildet und von einem Gehäuse für einen Stecker umgeben, dann läßt sich der Regler schnell und leicht anschließen. Das mit einem Stecker abgeschlossene Anschlußkabel braucht nur an dem Regler angesteckt zu werden.

Die Trägerplatte 1 kann auf einfache Weise bei Bedarf mit einem Kühlkörper 6 verbunden werden. Der Kühlkörper 6 kann durch Schrauben, Klemmen, Kleben oder Fugen mit der Trägerplatte 1 verbunden werden, wobei zur Verbesserung der thermischen Kopplung zwischen der Trägerplatte 1 und dem Kühlkörper 1 und dem Kühlkörper 6 eine wärmeleitende Paste aufgetragen werden kann.

Ist der Regler mit einem Temperaturfühler versehen, dann ergibt sich bei der direkten Kopplung der Chips mit der Trägerplatte 1 eine sehr gute thermische Kopplung zwischen den Leistungshalbleitern 2 und dem Temperaturfühler, der auch der Trägerplatte 1 oder auf dem Hybrid 3 plaziert sein kann. Der Temperaturfühler kann dann sehr schnell auf Temperaturänderungen an den Leistungshalbleitern 2 reagieren. Als Temperaturfühler wird dabei am einfachsten ein temperaturabhängiges Widerstandselement verwendet, das in gutem thermischem Kontakt mit der Trägerplatte 1 steht.

## Patentansprüche

1. Regler für einen Elektromotor, der mit Anschlüssen für den Elektromotor, eine Versorgungsspannung und mindestens einen externen Sollwert versehen ist und neben den elektronischen Bauelementen für die Regelschaltung mindestens einen Leistungshalbleiter als Leistungsendstufe aufweist,
**dadurch gekennzeichnet,**
**daß** alle elektronischen Bauelemente als Hybrid (3) in und/oder auf einem Keramiksubstrat enthalten und miteinander verbunden sind,
**daß** der Hybrid (3) auf einer wärmeleitenden Trägerplatte (1) befestigt ist, die mit einem Kühlkörper (6) verbindbar ist,
**daß** die Leistungshalbleiter (2) außerhalb des Hybrids (3) auf der Trägerplatte (1) befestigt und mit ihren Anschlußelektroden elektrisch leitend mit dem Hybrid (3) verbunden sind und
**daß** die Anschlüsse (4) des Reglers an dem Hybrid (3) zugänglich angebracht sind.

2. Regler nach Anspruch 1,
**dadurch gekennzeichnet,**
**daß** der Hybrid (3) mit der Trägerplatte (1) verklebt, verklemmt oder anderweitig mechanisch fest verbunden ist.

3. Regler nach Anspruch 1 oder 2,
**dadurch gekennzeichnet,**
**daß** die Anschlüsse (4) als Steckanschlüsse mit Gehäuse für einen Stecker ausgebildet sind.

4. Regler nach einem der Ansprüche 1 bis 3,
**dadurch gekennzeichnet,**
**daß** die Leistungshalbleiter (2) als Siliziumchips ausgebildet und mit der Trägerplatte (1) verklebt oder verlötet sind.

5. Regler nach Anspruch 4,
**dadurch gekennzeichnet,**
**daß** die Leistungshalbleiter (2) selbst und ihre Verbindungsleitungen (5) zu dem Hybrid (3) mittels einer Schutzschicht abgedeckt sind.

6. Regler nach einem der Ansprüche 1 bis 5,
**dadurch gekennzeichnet,**
**daß** bei einer Reglerschaltung mit Temperaturfühler diese in gut wärmeleitender Verbindung mit der Trägerplatte (1) auf dieser selbst oder im Hybrid (3) angeordnet sind.

7. Regler nach einem der Ansprüche 1 bis 6,
**dadurch gekennzeichnet,**
**daß** die Trägerplatte (1) aus Kupfer besteht.

8. Regler nach einem der Ansprüche 1 bis 7,
**dadurch gekennzeichnet,**
**daß** die Trägerplatte (1) über eine Schicht aus wärmeleitender Paste mechanisch fest mit dem Kühlkörper (6) verbunden ist.

9. Regler nach einem der Ansprüche 1 bis 8,
**dadurch gekennzeichnet,**
**daß** die Widerstände der Regelschaltung als gedruckte Hybridwiderstände ausgebildet sind.

## Claims

1. Controller for an electric motor, which is provided with connections for the electric motor, a supply voltage and at least one external setpoint value, and, in addition to the electronic components for the control circuit, has at least one power semiconductor as the power output stage,
**characterized**
**in that** all of the electronic components are accommodated in and/or on a ceramic substrate and are connected to one another as a hybrid (3),
**in that** the hybrid (3) is mounted on a thermally conductive mounting plate (1) which can be connected to a heat sink (6),
**in that** the power semiconductors (2) are mounted on the mounting plate (1) outside the hybrid (3) and their connection electrodes are electrically conductively connected to the hybrid (3), and
**in that** the connections (4) of the controller are attached to the hybrid (3) such that they are accessible.

2. Controller according to Claim 1,
**characterized**
**in that** the hybrid (3) is adhesively bonded, clamped or firmly mechanically connected in some other way to the mounting plate (1).

3. Controller according to Claim 1 or 2,
**characterized**
**in that** the connections (4) are in the form of plug connections with a housing for a plug.

4. Controller according to one of Claims 1 to 3,
**characterized**
**in that** the power semiconductors (2) are in the form of silicon chips and are adhesively bonded or soldered to the mounting plate (1).

5. Controller according to Claim 4,
**characterized**
**in that** the power semiconductors (2) themselves and their connecting lines (5) to the hybrid (3) are covered by a protective layer.

6. Controller according to one of Claims 1 to 5,
**characterized**
**in that**, in a controller circuit with temperature sensors, these temperature sensors are arranged with a good thermally conductive connection to the mounting plate (1) on the said mounting plate itself or in the hybrid (3).

7. Controller according to one of Claims 1 to 6,
**characterized**
**in that** the mounting plate (1) is composed of copper.

8. Controller according to one of Claims 1 to 7,
**characterized**
**in that** the mounting plate (1) is mechanically firmly connected to the heat sink (6) by means of a layer of thermally conductive paste.

9. Controller according to one of Claims 1 to 8,
**characterized**
**in that** the resistors of the control circuit are in the form of printed hybrid resistors.

## Revendications

1. Régulateur pour un moteur électrique, pourvu de connexions pour le moteur électrique, d'une tension d'alimentation et d'au moins une valeur de consigne externe et qui présente, outre les composants électroniques pour le circuit de régulation, au moins un semi-conducteur de puissance en tant qu'étage de sortie de puissance,
**caractérisé en ce que**
tous les composants électroniques sont disposés dans et/ou sur un substrat en céramique et reliés entre eux sous la forme d'un hybride (3), l'hybride (3) est fixé sur une plaque de support conductrice de chaleur (1) reliée à un corps de refroidissement (6),
les semi-conducteurs de puissance (2) sont fixés à l'extérieur de l'hybride (3) sur la plaque de support (1) et reliés avec leurs électrodes de connexion de façon électroconductrice à l'hybride (3), et
les connexions (4) du régulateur au niveau de l'hybride (3) sont accessibles.

2. Régulateur selon la revendication 1,
**caractérisé en ce que**
l'hybride (3) est relié mécaniquement de façon fixe à la plaque de support (1) par collage, par serrage ou par d'autres moyens.

3. Régulateur selon la revendication 1 ou 2,
**caractérisé en ce que**
les connexions (4) sont des connexions par fiches avec un boîtier pour un connecteur.

4. Régulateur selon l'une des revendications 1 à 3,
**caractérisé en ce que**
les semi-conducteurs de puissance (2) sont des puces en silicium collées ou soudées avec la plaque de support (1).

5. Régulateur selon la revendication 4,
**caractérisé en ce que**
les semi-conducteurs de puissance (2) eux-mêmes, ainsi que leurs lignes de connexion (5) menant à l'hybride (3), sont recouverts au moyen d'une couche de protection.

6. Régulateur selon l'une des revendications 1 à 5,
**caractérisé en ce que**
dans le cas d'un circuit de régulation comprenant des capteurs de température, ceux-ci sont disposés sur la plaque de support (1) ou dans l'hybride (3), de manière à être reliés de façon conductrice de chaleur à la plaque de support.

7. Régulateur selon l'une des revendications 1 à 6,
**caractérisé en ce que**
la plaque de support (1) se compose de cuivre.

8. Régulateur selon l'une des revendications 1 à 7,
**caractérisé en ce que**
la plaque de support (1) est reliée mécaniquement de façon fixe au corps de refroidissement (6) par le biais d'une couche constituée d'une pâte conductrice de chaleur.

9. Régulateur selon l'une des revendications 1 à 8,
**caractérisé en ce que**
les résistances du circuit de régulation sont des résistances hybrides imprimées.
